# EUROPÄISCHE PATENTSCHRIFT

(11) **EP 4 484 969 B1**
(45) Veröffentlichungstag und Bekanntmachung des Hinweises auf die Patenterteilung: **02.12.2026**
(21) Anmeldenummer: 23182644.7
(22) Anmeldetag: 30.06.2023
(51) Int. Cl.: G01R 19/175, G01R 19/22, G01R 19/25, G01R 23/10, G01R 35/00

(54) **GERÄT ZUM ÜBERWACHEN DES VORHANDENSEINS EINER SINUSFÖRMIGEN ELEKTRISCHEN SPANNUNG**
APPARATUS FOR MONITORING THE PRESENCE OF A SINUSOIDAL ELECTRIC VOLTAGE
APPAREIL POUR SURVEILLER LA PRÉSENCE D'UNE TENSION ÉLECTRIQUE SINUSOIDALE

(43) Veröffentlichungstag der Anmeldung: 01.01.2025
(73) Patentinhaber: Siteco GmbH, 83301 Traunreut (DE)
(72) Erfinder: Hofinger, Christoph, 83236 Übersee (DE); Rhein, Markus, 83329 Otting (DE)
(74) Vertreter: Schmidt, Steffen

(56) Entgegenhaltungen:
- DE-A1- 10 205 313
- DE-A1- 102017 006 131

## Beschreibung

Die vorliegende Erfindung betrifft ein Gerät zum Überwachen einer sinusförmigen Wechselspannung, um beispielsweise festzustellen, ob diese auf eine Gleichspannung umgeschaltet wurde oder um die Frequenz oder Amplitude der sinusförmigen Wechselspannung zu messen.

Geräte der eingangs beschriebenen Art werden insbesondere bei der Spannungsversorgung, z.B. für Versorgungsnetzwerke in Gebäuden oder in Verkehrswegeanlagen eingesetzt. Dazu sind jedoch in der Regel verschiedene Geräte notwendig und ein besonderes Problem ist dabei, die Messungen galvanisch getrennt von dem Versorgungsnetzwerk durchzuführen.

Im Stand der Technik ist es bekannt, Spannungen mit einem Analog/Digital-Wandler hinter einem Spannungsteiler abzutasten. Eine Gleichspannung ist dann mit der Kenntnis des genauen Spannungsteilerverhältnisses gut messbar. Die Messung des Effektivwertes oder des Scheitelwertes der Wechselspannung erfordert jedoch eine komplexe digitale Signalverarbeitung. Um eine solche Messelektronik auch galvanisch getrennt auszuführen, müssen vergleichsweise hochpreisige Trenntransformatoren zum Einsatz kommen.

Die DE 102 05 313 A1 offenbart ein Verfahren und eine Schaltungsanordnung zur potentialfreien Messung einer Eingangswechselspannung und deren Frequenz. Die Schaltungsanordnung zur potentialfreien Messung umfasst die Merkmale des Oberbegriffs des Anspruchs 1.

DE 10 2017 006 131 A1 offenbart ein Antriebssystem mit einer Anordnung zur Erkennung von Netzfehlern und Verfahren zur Erkennung von Netzfehlern. die Nulldurchgänge einer jeweiligen Phasenspannung des Wechselspannungsversorgungsnetzes werden detektiert, ein jeder Phasenspannung zugeordnetes binäres Signal erzeugt und die den Phasenspannungen zugeordneten Signale einem logischen Verknüpfungsmittel über eine galvanische Trennung, insbesondere über einen Optokoppler, zugeführt.

Aufgabe der vorliegenden Erfindung ist es, eine technisch einfache Lösung in einem Gerät bereitzustellen, welches die Überwachung einer sinusförmigen Wechselspannung ermöglicht und insbesondere auch die Möglichkeit bereitstellt, die Messung galvanisch getrennt von der Wechselspannung durchzuführen.

Gelöst wird die Aufgabe durch ein Gerät nach Anspruch 1 und ein Verfahren nach Anspruch 9.

Bei der erfindungsgemäßen Lösung wird in dem Gerät zunächst das zu überwachende Messsignal gleichgerichtet, jedoch ohne eine Glättung vorzunehmen. Beispielsweise kann mittels zweier Dioden eine negative Halbwelle der Wechselspannung abgeschnitten werden. In einem Komparator wird die gleichgerichtete, aber nicht geglättete Wechselspannung (welche optional auch noch mit einem Spannungsteiler heruntertransformiert werden kann) mit einer festen Referenzspannung verglichen. Der Komparator gibt unterschiedliche logischen Spannungspegel aus, welche als Funktion der Zeit anzeigen, ob die gleichgerichtete Wechselspannung (d.h. z.B. eine obere Halbwelle der sinusförmigen Wechselspannung) oberhalb oder unterhalb der festen Referenzspannung liegt. Die logischen Pegel lassen sich problemlos über eine galvanische Trennung, insbesondere über einen Optokoppler, zu einem Mikroprozessor übertragen, welcher allein aus der Abfolge der logischen Pegel überwachen kann, ob eine sinusförmige Wechselspannung vorliegt und ggf. sogar die Höhe der Wechselspannung sowie die Frequenz der Wechselspannung bestimmen kann. Erfindungsgemäß ist es daher nicht notwendig, mit einem Analog/Digital-Wandler das zu überwachende Signal vollständig abzutasten. Ein solcher Analog/Digital-Wandler kann erfindungsgemäß in der Schaltung des Geräts vollständig entfallen.

Gemäß einer bevorzugten Ausführungsform ist der Mikrokontroller eingerichtet, um aus einer Periodizität der eingehenden Pegel eine Frequenz der sinusförmigen Wechselspannung im Messsignal zu bestimmen. Dadurch lässt sich das erfindungsgemäße Gerät in einfacher Weise zur Bestimmung der Frequenz der zu überwachenden Wechselspannung nutzen. Die Frequenzmessung im Mikrokontroller ist vergleichsweise einfach zu implementieren, weil die Frequenz ermittelt werden kann, ohne das vollständige Signal der Wechselspannung abzutasten.

Gemäß einer bevorzugten Ausführungsform bestimmt der Mikrokontroller die Frequenz der sinusförmigen Wechselspannung mittels folgender Formel: $f = \frac{1}{dt 1 start - dt 0 start} ,$ wobei f die Frequenz der sinusförmigen Wechselspannung im Messsignal ist, *dt1start* der Startpunkt eines Pulses ist, welcher bei einem Wechsel vom ersten Pegel zum zweiten Pegel gemessen wird, und *dt0start* der Startpunkt eines vorherigen Pulses ist, welcher bei einem Wechsel vom ersten logischen Pegel zum zweiten logischen Pegel, der dem Wechsel bei *dt1start* unmittelbar vorhergeht, gemessen wird. Demnach muss der Mikrokontroller lediglich den zeitliche Abstand zwischen den Wechseln der logischen Pegel erfassen, jedoch nicht das vollständige Wechselspannungssignal abtasten.

Erfindungsgemäß ist der Mikrokontroller dafür eingerichtet, um aus einer Länge eines Pulses am Eingang des Mikrokontrollers, welcher dem ersten logischen Pegel entspricht, die Höhe einer Scheitelspannung oder eine effektive Spannung der sinusförmigen Wechselspannung im Messsignal zu ermitteln. Normalerweise ist die Messung der Scheitelspannung oder der effektiven Spannung einer Wechselspannung verhältnismäßig aufwändig, weil dazu ein Messgerät benötigt wird, welches über ein zeitliches Mittel aus der gleichgerichteten Wechselspannung den Effektivwert der Wechselspannung messen kann. Gemäß der vorliegenden Erfindung erfolgt die Messung lediglich durch die Länge eines Pulses, welcher zwischen dem Wechsel von dem ersten Pegel zum zweiten Pegel und vom zweiten Pegel zum ersten Pegel gemessen wird. Wenn man unterstellt, dass die Wechselspannung eine Sinusform aufweist, und der Spannungsreferenzwert, bei welchem der Wechsel von dem ersten zu dem zweiten Pegel stattfindet, bekannt ist, lässt sich daraus allein bereits der Wert der Spannung im Scheitelwert der Sinuskurve oder der Effektivwert einer sinusförmigen Wechselspannung ermitteln.

Die Einrichtung zur galvanischen Trennung ist ein Optokoppler. Ein Optokoppler ist eine besonders einfache technische Möglichkeit, um eine Trennung zwischen dem zu messenden Signal mit der Wechselspannung und dem Mikrokontroller vorzunehmen. Dadurch ist der Mikrokontroller vor Spannungsspitzen, die ggf. durch das zu messende Signal in die Schaltung induziert werden, geschützt.

Erfindungsgemäß bestimmt der Mikrokontroller die Scheitelspannung der sinusförmigen Wechselspannung mittels folgender Formel: $\hat{u} = \frac{{u}_{schweii}}{cos \left(π∗f∗\left(dt-topto\right)\right)} + udrop ,$ wobei *û* die Scheitelspannung der sinusförmigen Wechselspannung ist, *u_{schwell}* der feste Referenzspannungswert im Komparator ist, welcher ggf. noch um einen Faktor korrigiert ist, wenn das Messignal vor dem Komparator durch einen optional vorhandenen Spannungsteiler heruntertransformiert ist, dt eine vom Komparator generierte Pulsbreite ist, in welcher durchgängig der zweite logische Pegel am Mikrokontroller empfangen wird, *udrop* ein Spannungsabfall an dem Gleichrichter und an gegebenenfalls vorhandenen elektrischen Bauelementen ist, welche zusätzlich zu dem Gleichrichter noch zwischen dem zu überwachenden Messignal und dem Eingang des Komparators vorhanden sind (z.B. Filterspulen oder Ähnliches in einem Netzeingang eine zu überwachenden Netzwerkwechselspannung), und *topto* eine Latenzzeit der Einrichtung zur galvanischen Trennung ist. Der Wert für *udrop* ist immer zu berücksichtigen, da wenigstens am Gleichrichter immer eine Spannung abfällt. Der Wert für *topto* ist zu berücksichtigen, weil in der Schaltung ein Optokoppler eingesetzt wird, welcher eine Latenzzeit beim Schalten vom ersten zum zweiten Pegel aufweist. Die Berechnung des Scheitelspannung *û* erfolgt auf Basis eines positiven Impulses, der von dem Optokoppler ausgegeben wird. Beim Durchschalten des Optokopplers (positive Flanke) ist die Latenzzeit nicht signifikant, der Optokoppler schaltet sofort durch. Beim Sperren des Transistors im Optokoppler müssen hingegen parasitären Kapazitäten im Silizium des Optokopplers entladen werden, was eine gewisse Zeit beansprucht. Daher ist der positive Puls einmalig um die Latenzzeit zu lange, der negative Puls ist einmalig um die Latenzzeit zu kurz. Daher muss die Latenzzeit *topto* von der Pulslänge dt bei der Berechnung von *û* abgezogen werden. Die Formel gibt demnach eine einfache Möglichkeit, um die Scheitelspannung der sinusförmigen Wechselspannung aus dem Messsignal zu bestimmen, ohne eine direkte Spannungsmessung vorzunehmen. In der Formel ist unterstellt, dass die Wechselspannung tatsächlich sinusförmig ist. Dadurch lässt sich alleine durch die gemessene Pulsbreite sowie ggf. anderen gegebenen festen Parametern die Scheitelspannung der Wechselspannung ermitteln.

Gemäß einer bevorzugten Ausführungsform ist der Gleichrichter dafür eingerichtet, nur eine positive Halbwelle der sinusförmigen Wechselspannung von dem zu überwachenden Messsignal zu dem Komparator durchzulassen. Insbesondere ist gemäß einer bevorzugten Ausführungsform der Gleichrichter aus wenigstens einer, vorzugsweise aus zwei einfache Dioden gebildet. Dies ist die technisch einfachste Realisierung, um die zu messende Wechselspannung gleichzurichten, ohne diese zu glätten.

Gemäß einer bevorzugten Ausführungsform ist zwischen dem Gleichrichter und dem Komparator oder zwischen dem Eingang für das zu überwachende Messsignal und dem Komparator eine Einrichtung, insbesondere ein Spannungsteiler, vorgesehen, um die Spannung herunterzutransformieren. Die Einrichtung zum Heruntertransformieren der Messspannung lässt sich durch einen Spannungsteiler einfach realisieren, welcher zwischen dem Plus des Gleichrichters und dem Minus des Gleichrichters geschaltet ist, wobei der Abgriff des Spannungsteilers mit dem Eingang des Komparators verbunden ist. Das Verhältnis der Widerstände im Spannungsteiler wird so gewählt, dass die zu messende Spannung so weit heruntertransformiert wird, dass sie in einem von dem Komparator zu verarbeitenden Bereich liegen, d.h. insbesondere ohne den Komparator zu schädigen.

Gemäß einer bevorzugten Ausführungsform umfasst der Komparator einen Operationsverstärker und ist insbesondere durch eine integrierte Schaltung des Typs TL431 gebildet. Diese Bauteile sind besonders geeignet, um aus dem Ergebnis des Vergleichs zwischen der gleichgerichteten Wechselspannung und der festen Referenzspannung logische Spannungspegel zu erzeugen. Die Spannungspegel können z.B. bei 0V und bei einer festen Voltzahl zwischen 1,5V und 5V liegen. Diese zwei logischen Pegel eignen sich entweder direkt zur Verarbeitung in einem Mikrokontroller oder, wie in der vorliegenden Erfindung, zur Übertragung in einem Bauteil zur galvanischen Trennung und anschließenden Verarbeitung in einem Mikrokontroller. Eine integrierte Schaltung des Typs TL431 ist beispielsweise in der englischen Fassung von Wikipedia in der Fassung vom Anmeldetag der vorliegenden Patentanmeldung enthalten. Das Bauteil TL431 hat lt. Datenblatt einen Referenzspannungswert von 2495mV, der nicht veränderbar ist. Trotz des festen Referenzspannungswertes kann der Wert für *u_{schwell}* aber durch die Verwendung eines Spannungsteilers vor dem Eingang des Komparators, wie vorhergehend beschrieben, angepasst werden. So lässt sich z.B. eine sinusförmige Wechselspannung mit einer Scheitelspannung *û* von über 100V oder 200V überwachen. Dazu wird *u_{schwell}* auf einen Wert etwas unterhalb von *û* mittels des Spannungsteilers vor dem Eingang des Komparators eingestellt.

Ein weiterer Aspekt der Erfindung betrifft das Kalibrieren des Gerätes gemäß dem Verfahren nach Anspruch 9 sowie Geräte nach Anspruch 10 und 11.

Weitere Vorteile und Merkmale der vorliegenden Erfindung werden nachfolgend in Verbindung mit den Figuren beschrieben. In den Figuren ist Folgendes dargestellt:
- Figur 1: zeigt ein Diagramm, in welchem die zu überwachende Wechselspannung als Funktion der Zeit über eine Periode dargestellt ist.
- Figur 2: zeigt ein schematisches Schaltbild des Aufbaus eines erfindungsgemäßen Gerätes zur Überwachung einer Wechselspannung.

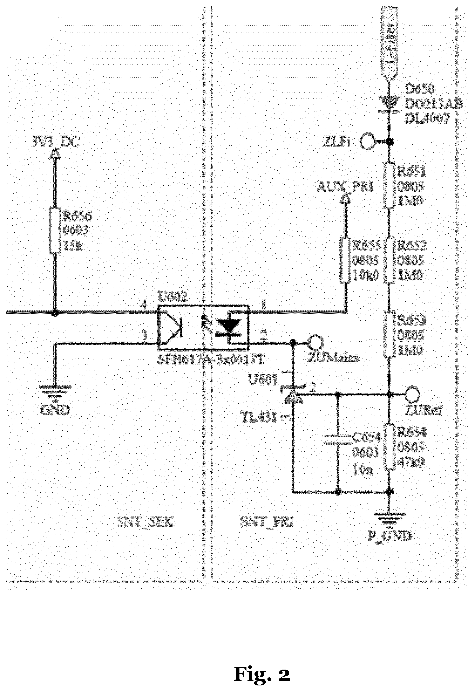

Mit Bezug auf Figur 2 wird die Schaltung in einem Gerät zur Überwachung einer Wechselspannung gemäß der vorliegenden Erfindung erläutert. An einem Filter (in der Figur 2 mit L-Filter bezeichnet) liegt ein Außenleiter, der eine Phase L einer Netzspannung führt, an. Die Netzspannung enthält eine Wechselspannung, welche mit dem erfindungsgemäßen Gerät überwacht werden soll. Der Ausgang von L-Filter ist über eine Diode D650, welche als Gleichrichter wirkt, ohne die Wechselspannung zu glätten, und über einen Spannungsteiler R651 bis R654 mit P_GND verbunden. P_GND ist mit dem N-Leiter der Netzspannung über eine zweite Diode des Gleichrichters verbunden (in der Figur 2 nicht dargestellt). Die von den Dioden herausgeschnittene positive Halbwelle der zu überwachenden Wechselspannung wird über den Spannungsteiler R651 bis R654 an einem Mittelabgriff (zwischen R653 und R654) auf eine Spannung herabtransformiert, welche für einen Referenzbaustein U601, der als Komparator dient, als Eingang dient. Der Baustein U601 ist durch eine integrierte Schaltung des Typs TL431 gebildet. Die integrierte Schaltung TL431 ist eine integrierte Schaltung mit drei Eingängen, welche als anpassbarer präziser Shunt-Spannungsregulator dient.

An einem Eingang AUX_PRI der Schaltung liegt eine mittels Kondensatoren gepufferte Hilfsspannung an. Die an AUX_PRI anliegende Hilfsspannung ist mit einem Widerstand R655 mit einem Eingang 1 eines Optokopplers U602 verbunden. Ferner liegt der Eingang 1 des Referenzbausteins U601 am Eingang 2 des Optokopplers U602 an. Zwischen den Eingängen 1 und 2 des Optokopplers U602 liegt durch die Schaltung wie vorhergehend beschrieben ein logischer Spannungspegel an, welcher über den Optokoppler U602 auf eine Sekundärseite SNT_SEK der Schaltung, die galvanisch von der Primärseite SNT_PRI der Schaltung getrennt ist, übertragen wird. An der Sekundärseite des Optokopplers liegt der Ausgang 3 an Erde an und der Ausgang 4 des Optokopplers ist unmittelbar mit einem Eingang eines Mikrokontrollers (in der Schaltung nicht dargestellt) verbunden.

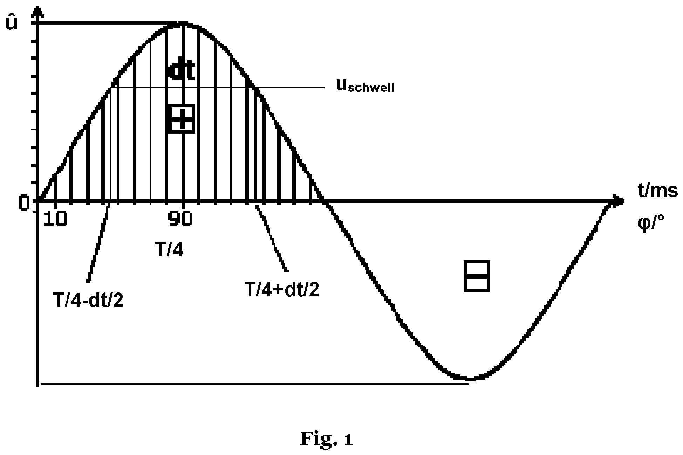

Das Messprinzip wird nachfolgend in Verbindung mit Figur 1 erläutert.

Die zu überwachende Wechselspannung ist schematisch in Figur 1 als Funktion der Zeit über eine Periode T dargestellt. Die Wechselspannung weist einen Scheitelwert *û* auf. Durch den Gleichrichter, wie vorhergehend beschrieben, wird der negative Anteil der Wechselspannung abgeschnitten, so dass nur der in Figur 1 schraffierte Anteil der positiven Halbwelle zur anschließenden Messung im Komparator verbleibt. Der Komparator des Bausteins U601 vergleicht die im Spannungsteiler R651 bis R654 zwischen den Widerständen R653 und R654 anliegende Spannung mit einer internen festen Referenzspannung. Wenn die überwachte Wechselspannung einen Schwellenwert *u_{schwell}* unterschreitet, liegt ein erster logischer Spannungspegel zwischen den Eingängen 1 und 2 des Optokopplers an. Wenn die Wechselspannung den Schwellenwert *u_{schwell}* überschreitet, liegt ein zweiter logischer Spannungspegel zwischen den Eingängen 1 und 2 des Optokopplers an. Eine von dem Komparator generierte Pulsbreite, über welche durchgängig der zweite logische Spannungspegel erzeugt wird, ist in der Figur 1 über die Zeit dt eingezeichnet. Mit dem bekannten Schwellenwert *u_{schwell}* und dem Spannungsabfall an vorgelagerten Filter- und Gleichrichterbauelementen *udrop* kann der Scheitelwert *û* der überwachten Wechselspannung mittels folgender Gleichung ermittelt werden: $\hat{u} = \frac{{u}_{schweii}}{cos \left(π∗f∗dt\right)} + udrop$ (1)

Die Bestimmung des Scheitelwerts *û* erfolgt in dem Mikrokontroller auf der Sekundärseite SNT_SEK des Optokopplers U602.

Ferner wird auch die Frequenz f der zu überwachenden Wechselspannung bestimmt. Wenn *dt1start* der Startpunkt eines Pulses dt ist und *dt0start* der Startpunkt eines vorhergehenden Pulses dt ist, lässt sich die Frequenz f der zu überwachenden Wechselspannung durch folgende Formel bestimmen: $f = \frac{1}{dt 1 start - dt 0 start}$

Sobald die Pulse (d.h. der Wechsel von dem ersten zum zweiten logischen Spannungspegel) ausbleiben, wird vom Mikrokontroller detektiert, dass die Wechselspannung nicht mehr vorhanden ist. Ferner kann durch den Pegel am Eingang des Mikrokontrollers auch unterschieden werden, ob am L-Filter noch eine Gleichspannung anliegt oder ob die Spannungsversorgung vollständig abgeschaltet wurde.

Da alle Informationen der zu überwachenden Spannungsversorgung mit logischen Pegeln und deren zeitlichen Verläufen kodiert sind, lässt sich das Signal einfach mit dem Optokoppler U602 zur galvanischen Trennung des Versorgungsstromkreises auf der Primärseite des Optokopplers und des Mess-Stromkreises auf der Sekundärseite des Optokopplers implementieren. Um die durch den Optokoppler induzierten Verzögerungen zu kompensieren, muss allerdings die Formel (1) um die Latenzzeit des Optokopplers *topto* erweitert werden: $\hat{u} = \frac{{u}_{schweii}}{cos \left(π∗f∗\left(dt-topto\right)\right)} + udrop$

Nachdem der Spannungsteiler und insbesondere der Optokoppler Toleranzen aufweisen, ist es vorteilhaft die Schaltung zu kalibrieren. Hierfür wurden Formeln ermittelt, welche es ermöglichen, die Schaltspannung und die Optokoppler-Latenzzeit aus zwei gemessenen Wertepaaren von Eingangsspannung und Gesamtpulsbreite zu errechnen: $uschwell = \sqrt{\left(\frac{{\left(\hat{u}1\right)}^{2} ∗ {\left(\hat{u}2\right)}^{2} ∗ \left({cos}^{2}\left(π∗f∗\left(dt 1 μC-dt 2 μC\right)\right)-1\right)}{2 ∗ \left(\hat{u}1\right) ∗ \left(\hat{u}2\right) ∗ cos \left(π∗f∗\left(dt 1 μC-dt 2 μC\right)\right) - {\left(\hat{u}1\right)}^{2} - {\left(\hat{u}2\right)}^{2}}\right)}$ $topto = \frac{arctan \left(\frac{{u}_{eff 1} ∗ cos \left(π∗f∗dt 1 μC\right) - {u}_{eff 2} ∗ cos \left(π∗f∗dt 2 μC\right)}{{u}_{ef f 2} ∗ sin \left(π∗f∗dt 2 μC\right) - {u}_{eff 1} ∗ sin \left(π∗f∗dt 1 μC\right)}\right)}{π ∗ f}$

Dabei stellen *û1* und û2 die Scheitelwerte an der überwachten Wechselspannung an einem gemessenen Wertepaaren dar. Ferner stellen *dt1µC* und *dt2µC* die Pulszeiten des positiven Impulses (d.h. die Zeit, in welcher die überwachte Wechselspannung über *u_{schwell}* liegt) entsprechend dem zweiten logischen Pegel, welche am Eingang des Mikrokontrollers anliegen, dar. Schließlich stellen *u_{eff1}* und *u_{eff2}* die Effektivwerte der Wechselspannung an dem gemessenen Wertenpaar dar (d.h. *û1 = √2 u_{eff1}* und *û*2 = √2 *u_{eff2}*).

Die analogen Messwerte können nicht ohne Verzögerung über den Optokoppler übertragen werden. Dieser Effekt ist jedoch durch die Berücksichtigung der Latenzzeit des Optokopplers wie oben beschrieben ausgeglichen. Demnach ist es mit der erfindungsgemäßen Schaltung möglich, alle analogen Parameter in logischen Pegel und Zeitspannen umzuwandeln und dann digital und galvanisch getrennt von der Messseite auszuwerten.

Dadurch ist es insbesondere möglich, das Ausbleiben einer Wechselspannung bei einer Unterbrechung der Netzversorgung zu erkennen. Ferner ist es auch möglich, eine Überwachung vorzunehmen, ob die Wechselspannung auf eine Gleichspannung umgeschaltet wurde. Wenn eine Gleichstromversorgung erkannt wurde, kann dadurch beispielsweise die Leistung an einem Netzteil eines Verbrauchers, der mit der überwachten Netzspannung versorgt wird, reduziert werden, um eine Belastung der Bauteile wie z.B. einen Netzgleichrichter zu verhindern. Vor allem im Bereich der Beleuchtungstechnik ist eine solche Überwachung wünschenswert. Beispielsweise kann die Netzversorgung der Geräte bei einer Gleichstromversorgung erkannt und ggf. die Helligkeit der Leuchtmittel reduziert werden.

Durch die Messung der Frequenz und der Amplitude (Scheitelwert) der sinusförmigen Wechselspannungen kann eine zu hohe Netzspannung erkannt werden und entsprechend ein Verbrauchergerät, welches mit der überwachten Wechselspannung betrieben wird, in einem Schutzzustand versetzt werden, bis der Fehlerzustand behoben wurde.

Die erfindungsgemäße Schaltung bietet daher eine relativ kostengünstige Möglichkeit, um eine Wechselspannung zu überwachen, und im kalibrierten Zustand auch eine genaue Möglichkeit der Spannungs- und Frequenzmessung der zu überwachenden Wechselspannung.

## Patentansprüche

1. Gerät zum Überwachen des Vorhandenseins einer sinusförmigen Wechselspannung, wobei das Gerät Folgendes aufweist:
einen Eingang für ein zu überwachendes Messsignal;
einen Gleichrichter, welcher eingerichtet ist, das Messsignal gleichzurichten, ohne es zu glätten, um ein gleichgerichtetes Messsignal zu erzeugen;
einen Komparator, welcher eingerichtet ist, das gleichgerichtete Messsignal mit einem festen Referenzspannungswert zu vergleichen und einen ersten logischen Pegel auszugeben, wenn das gleichgerichtete Messsignal höher als die Referenzspannung ist, und einen zweiten logischen Pegel, der sich von dem ersten logischen Pegel unterscheidet, auszugeben, wenn das gleichgerichtete Messsignal kleiner oder gleich der Referenzspannung ist;
eine Einrichtung zur galvanischen Trennung, welche auf einer Eingangsseite die logischen Pegel empfängt und auf einer Ausgangsseite nach der galvanischen Trennung die logischen Pegel einem Mikrokontroller zuführt,
wobei der Mikrokontroller eingerichtet ist, um eine Periodizität in den zugeführten logischen Pegeln zu ermitteln und bei Nichtvorhandensein einer Periodizität ein Ausgangssignal bereitzustellen, welches anzeigt, dass das Messsignal keine sinusförmige Wechselspannung aufweist,
wobei der Mikrokontroller dafür eingerichtet ist, um aus einer Länge eines Pulses am Eingang des Mikrokontrollers, welcher dem ersten logischen Pegel entspricht, die Höhe einer Scheitelspannung oder eine effektive Spannung der sinusförmigen Wechselspannung im Messsignal zu ermitteln,
wobei der Mikrokontroller die Scheitelspannung des sinusförmigen Wechselstroms mittels folgender Formel bestimmt: $\hat{u} = \frac{{u}_{schweii}}{cos \left(π∗f∗\left(dt-topto\right)\right)} + udrop ,$
wobei *û* die Scheitelspannung der sinusförmigen Wechselspannung ist, *u_{schwell}* ein Schwellenwert ist, welcher dem Referenzspannungswert im Komparator entspricht und optional noch um einen Faktor korrigiert ist, wenn das Messignal vor dem Komparator durch einen optional vorhandenen Spannungsteiler heruntertransformiert ist, dt eine vom Komparator generierte Pulsbreite ist, in welcher durchgängig der zweite logische Pegel am Mikrokontroller empfangen wird, **dadurch gekennzeichnet, dass** *udrop* ein Spannungsabfall an dem Gleichrichter und an gegebenenfalls vorhandenen elektrischen Bauelementen ist, welche zusätzlich zu dem Gleichrichter noch zwischen dem Eingang für das zu überwachende Messignal und dem Eingang des Komparators vorhanden sind, und *topto* die Latenzzeit eines Optokopplers der galvanischen Trennung ist.

2. Gerät nach Anspruch 1, wobei der Mikrokontroller eingerichtet ist, um aus einer Periodizität in einer Abfolge der dem Microkontroller zugeführten ersten und zweiten logischen Pegel eine Frequenz der sinusförmigen Wechselspannung im Messsignal zu bestimmen.

3. Gerät nach Anspruch 2, wobei der Mikrokontroller die Frequenz der sinusförmigen Wechselspannung mittels folgender Formel bestimmt: $f = \frac{1}{dt 1 start - dt 0 start}$ wobei *f* die Frequenz der sinusförmigen Wechselspannung im Messsignal ist, *dt1start* der Startpunkt eines Pulses ist, welcher bei einem Wechsel vom ersten Pegel zum zweiten Pegel gemessen wird, und *dt0start* der Startpunkt eines vorherigen Pulses ist, welcher bei einem Wechsel vom ersten logischen Pegel zum zweiten logischen Pegel, der dem Wechsel bei *dt1start* unmittelbar vorhergeht, gemessen wird.

4. Gerät nach einem der vorhergehenden Ansprüche, wobei die Einrichtung zur galvanischen Trennung ein Optokoppler ist.

5. Gerät nach einem der vorhergehenden Ansprüche, wobei der Komparator durch einen Operationsverstärker umfasst und insbesondere durch eine integrierte Schaltung des Typs TL431 gebildet ist.

6. Gerät nach einem der vorhergehenden Ansprüche, wobei der Gleichrichter dafür eingerichtet ist, nur eine positive Halbwelle der sinusförmigen Wechselspannung von dem zu überwachenden Messsignal zu dem Komparator durchzulassen.

7. Gerät nach einem der vorhergehenden Ansprüche, wobei der Gleichrichter wenigstens eine, vorzugsweise zwei Dioden umfasst.

8. Gerät nach einem der vorhergehenden Ansprüche, wobei zwischen dem Gleichrichter und dem Komparator oder zwischen dem Eingang für das zu überwachende Messsignal und dem Komparator eine Einrichtung, insbesondere ein Spannungsteiler, vorgesehen ist, um die Spannung herunterzutransformieren.

9. Verfahren zum Kalibrieren eines Gerätes nach einem der vorhergehenden Ansprüche, wobei der Verfahren folgende Schritte aufweist:
Durchführen von zwei Messungen mittels des noch nicht kalibrierten Geräts für zwei verschiedene Wechselspannungen, die bekannte Scheitelspannungen *û1* und ü2, bekannte Effektivspannungen *u_{eff1}* und *u_{eff2},* und eine bekannte Frequenz *f* aufweisen, und dabei Erfassen von zwei Pulsbreiten *dt1µC* und *dt2µC,* welche durch die Zeitlängen bestimmt sind, in denen der erste logische Pegel am Mikrokontroller innerhalb einer Periode der jeweils gemessenen Wechselspannung anliegt;
Berechnen der Parameter *u_{schwell}* und *topto* mittels der Formeln: $uschwell = \sqrt{\left(\frac{{\left(\hat{u}1\right)}^{2} ∗ {\left(\hat{u}2\right)}^{2} ∗ \left({cos}^{2}\left(π∗f∗\left(dt 1 μC-dt 2 μC\right)\right)-1\right)}{2 ∗ \left(\hat{u}1\right) ∗ \left(\hat{u}2\right) ∗ cos \left(π∗f∗\left(dt 1 μC-dt 2 μC\right)\right) - {\left(\hat{u}1\right)}^{2} - {\left(\hat{u}2\right)}^{2}}\right)}$ und $topto = \frac{arctan \left(\frac{{u}_{eff 1} ∗ cos \left(π∗f∗dt 1 μC\right) - {u}_{eff 2} ∗ cos \left(π∗f∗dt 2 μC\right)}{{u}_{ef f 2} ∗ sin \left(π∗f∗dt 2 μC\right) - {u}_{eff 1} ∗ sin \left(π∗f∗dt 1 μC\right)}\right)}{π ∗ f} ;$ und
Speichern der Parameter *u_{schwell}* und *topto* in einem Speicher des Mikrokontrollers.

10. Gerät nach einem der Ansprüche 1 bis 8, welches nach dem Verfahren gemäß Anspruch 9 kalibriert ist.

11. Gerät nach einem der Ansprüche 1 bis 8, welches mit einer Funktion zur automatischen Kalibrierung entsprechend dem Verfahren nach Anspruch 9 eingerichtet ist.

## Claims

1. An apparatus for monitoring the presence of a sinusoidal AC voltage, the apparatus comprising:
an input for a measurement signal to be monitored;
a rectifier configured to rectify the measurement signal without smoothing it to produce a rectified measurement signal;
a comparator configured to compare the rectified measurement signal with a fixed reference voltage value and to output a first logic level when the rectified measurement signal is higher than the reference voltage and to output a second logic level different from the first logic level when the rectified measurement signal is less than or equal to the reference voltage;
a galvanic isolation means receiving the logic levels on an input side and supplying the logic levels to a microcontroller on an output side after the galvanic isolation,
wherein the microcontroller is configured to determine a periodicity in the supplied logic levels and, in the absence of a periodicity, to provide an output signal indicating that the measurement signal does not comprise a sinusoidal AC voltage,
wherein the microcontroller is configured to determine the level of a peak voltage or an effective voltage of the sinusoidal AC voltage in the measurement signal from a length of a pulse at the input of the microcontroller corresponding to the first logic level,
wherein the microcontroller determines the peak voltage of the sinusoidal AC voltage by means of the following formula: $\hat{u} = \frac{{u}_{schweii}}{cos \left(π∗f∗\left(dt-topto\right)\right)} + udrop ,$
wherein *û* is the peak voltage of the sinusoidal AC voltage, *u_{schwell}* is a threshold value corresponding to the reference voltage value in the comparator and optionally is still corrected by a factor if the measurement signal is transformed down by an optionally present voltage divider upstream of the comparator, *dt* is a pulse width generated by the comparator in which the second logic level is continuously received at the microcontroller, **characterized in that** *udrop* is a voltage drop at the rectifier and at optionally present electrical components which, in addition to the rectifier, are still present between the input for the measurement signal to be monitored and the input of the comparator, and *topto* is the latency time of an optocoupler of the galvanic isolation.

2. The apparatus according to claim 1, wherein the microcontroller is configured to determine a frequency of the sinusoidal AC voltage in the measurement signal from a periodicity in a sequence of the first and second logic levels supplied to the microcontroller.

3. The apparatus according to claim 2, wherein the microcontroller determines the frequency of the sinusoidal AC voltage by means of the following formula: $f = \frac{1}{dt 1 start - dt 0 start} ,$ wherein *f* is the frequency of the sinusoidal AC voltage in the measurement signal, *dt1start* is the starting point of a pulse measured during a change from the first level to the second level, and *dt0start* is the starting point of a previous pulse measured during a change from the first logic level to the second logic level immediately preceding the change at *dt1start*.

4. The apparatus according to any one of the preceding claims, wherein the galvanic isolation means is an optocoupler.

5. The apparatus according to any one of the preceding claims, wherein the comparator comprises an operational amplifier and is in particular formed by an integrated circuit of type TL431.

6. The apparatus according to any one of the preceding claims, wherein the rectifier is configured to pass only a positive half-wave of the sinusoidal AC voltage from the measurement signal to be monitored to the comparator.

7. The apparatus according to any one of the preceding claims, wherein the rectifier comprises at least one, preferably two diodes.

8. The apparatus according to any one of the preceding claims, wherein a means, in particular a voltage divider, is provided between the rectifier and the comparator or between the input for the measurement signal to be monitored and the comparator for stepping down the voltage.

9. A method for calibrating an apparatus according to any one of the preceding claims, the method comprising the steps of:
performing two measurements by means of the not yet calibrated apparatus for two different AC voltages, which have known peak voltages *û1* and û2, known root mean square voltages *u_{eff1}* and *u_{eff2}*, and a known frequency *f*, and thereby detecting two pulse widths *dt1 µC* and *dt2 µC,* which are determined by the time lengths in which the first logic level is applied to the microcontroller within a period of the respectively measured AC voltage;
calculating the parameters *u_{schwell}* and *topto* by means of the formulas: $uschwell = \sqrt{\left(\frac{{\left(\hat{u}1\right)}^{2} ∗ {\left(\hat{u}2\right)}^{2} ∗ \left({cos}^{2}\left(π∗f∗\left(dt 1 μC-dt 2 μC\right)\right)-1\right)}{2 ∗ \left(\hat{u}1\right) ∗ \left(\hat{u}2\right) ∗ cos \left(π∗f∗\left(dt 1 μC-dt 2 μC\right)\right) - {\left(\hat{u}1\right)}^{2} - {\left(\hat{u}2\right)}^{2}}\right)}$ and $topto = \frac{arctan \left(\frac{{u}_{eff 1} ∗ cos \left(π∗f∗dt 1 μC\right) - {u}_{eff 2} ∗ cos \left(π∗f∗dt 2 μC\right)}{{u}_{ef f 2} ∗ sin \left(π∗f∗dt 2 μC\right) - {u}_{eff 1} ∗ sin \left(π∗f∗dt 1 μC\right)}\right)}{π ∗ f} ;$ and
storing the parameters *u_{schwell}* and *topto* in a memory of the microcontroller.

10. The apparatus according to any one of claims 1 to 8, which is calibrated according to the method of claim 9.

11. The apparatus according to any one of claims 1 to 8, which is configured with a function for automatic calibration according to the method of claim 9.

## Revendications

1. Appareil pour surveiller la présence d'une tension alternative sinusoïdale, l'appareil comprenant :
une entrée pour un signal de mesure à surveiller ;
un redresseur configuré pour redresser le signal de mesure sans le lisser afin de générer un signal de mesure redressé ;
un comparateur configuré pour comparer le signal de mesure redressé à une valeur de tension de référence fixe et pour délivrer un premier niveau logique lorsque le signal de mesure redressé est supérieur à la tension de référence et pour délivrer un second niveau logique différent du premier niveau logique lorsque le signal de mesure redressé est inférieur ou égal à la tension de référence ;
un moyen de séparation galvanique qui reçoit les niveaux logiques sur un côté d'entrée et fournit les niveaux logiques à un microcontrôleur sur un côté de sortie après la séparation galvanique,
dans lequel le microcontrôleur est configuré pour déterminer une périodicité dans les niveaux logiques fournis et, en l'absence d'une périodicité, pour fournir un signal de sortie indiquant que le signal de mesure ne comprend pas de tension alternative sinusoïdale,
dans lequel le microcontrôleur est configuré pour déterminer, à partir d'une longueur d'une impulsion à l'entrée du microcontrôleur correspondant au premier niveau logique, le niveau d'une tension de crête ou d'une tension efficace de la tension alternative sinusoïdale dans le signal de mesure,
dans lequel le microcontrôleur détermine la tension de crête du courant alternatif sinusoïdal au moyen de la formule suivante : $\hat{u} = \frac{{u}_{schweii}}{cos \left(π∗f∗\left(dt-topto\right)\right)} + udrop ,$
dans lequel *û* est la tension de crête de la tension alternative sinusoïdale, *u_{schwell}* est une valeur de seuil qui correspond à la valeur de tension de référence dans le comparateur et est facultativement encore corrigée d'un facteur lorsque le signal de mesure est transformé et rabaissé en amont du comparateur par un diviseur de tension facultativement présent, dt est une largeur d'impulsion générée par le comparateur dans laquelle le deuxième niveau logique est reçu en continu au niveau du microcontrôleur, **caractérisé en ce que** *udrop* est une baisse de tension au niveau du redresseur et de composants électriques éventuellement présents qui sont encore présents en plus du redresseur entre l'entrée pour le signal de mesure à surveiller et l'entrée du comparateur, et *topto* est le temps de latence d'un optocoupleur de la séparation galvanique.

2. Appareil selon la revendication 1, dans lequel le microcontrôleur est configuré pour déterminer, à partir d'une périodicité dans une séquence des premier et deuxième niveaux logiques fournis au microcontrôleur, une fréquence de la tension alternative sinusoïdale dans le signal de mesure.

3. Appareil selon la revendication 2, dans lequel le microcontrôleur détermine la fréquence de la tension alternative sinusoïdale au moyen de la formule suivante : $f = \frac{1}{dt 1 start - dt 0 start} ,$ où f est la fréquence de la tension alternative sinusoïdale dans le signal de mesure, *dt1start* est le point de départ d'une impulsion mesurée lors d'un changement du premier niveau au deuxième niveau, et *dt0start* est le point de départ d'une impulsion précédente mesurée lors d'un changement du premier niveau logique au deuxième niveau logique précédant immédiatement le changement à *dt1start.*

4. Appareil selon l'une quelconque des revendications précédentes, dans lequel le moyen de séparation galvanique est un optocoupleur.

5. Appareil selon l'une quelconque des revendications précédentes, dans lequel le comparateur comprend un amplificateur opérationnel et est formé en particulier par un circuit intégré de type TL431.

6. Appareil selon l'une quelconque des revendications précédentes, dans lequel le redresseur est configuré pour faire passer seulement une demi-onde positive de la tension alternative sinusoïdale du signal de mesure à surveiller au comparateur.

7. Appareil selon l'une quelconque des revendications précédentes, dans lequel le redresseur comprend au moins une, de préférence deux diodes.

8. Appareil selon l'une quelconque des revendications précédentes, dans lequel un moyen, en particulier un diviseur de tension, est prévu entre le redresseur et le comparateur ou entre l'entrée pour le signal de mesure à surveiller et le comparateur afin de réduire la tension.

9. Procédé de calibrage d'un appareil selon l'une quelconque des revendications précédentes, le procédé comprenant les étapes suivantes :
la réalisation de deux mesures au moyen de l'appareil non encore calibré pour deux tensions alternatives différentes, qui comprennent des tensions de crête connues *û1* et û2, des tensions efficaces connues *u_{eff1}* et *u_{eff2}*, et une fréquence connue *f*, et ainsi détection de deux largeurs d'impulsion *dt1µC* et *dt2µC,* qui sont déterminées par les laps de temps pendant lesquels le premier niveau logique est appliqué au microcontrôleur dans une période de la tension alternative respectivement mesurée ;
le calcul des paramètres *u_{schwell}* et *topto* au moyen des formules : $uschwell = \sqrt{\left(\frac{{\left(\hat{u}1\right)}^{2} ∗ {\left(\hat{u}2\right)}^{2} ∗ \left({cos}^{2}\left(π∗f∗\left(dt 1 μC-dt 2 μC\right)\right)-1\right)}{2 ∗ \left(\hat{u}1\right) ∗ \left(\hat{u}2\right) ∗ cos \left(π∗f∗\left(dt 1 μC-dt 2 μC\right)\right) - {\left(\hat{u}1\right)}^{2} - {\left(\hat{u}2\right)}^{2}}\right)}$ et $topto = \frac{arctan \left(\frac{{u}_{eff 1} ∗ cos \left(π∗f∗dt 1 μC\right) - {u}_{eff 2} ∗ cos \left(π∗f∗dt 2 μC\right)}{{u}_{ef f 2} ∗ sin \left(π∗f∗dt 2 μC\right) - {u}_{eff 1} ∗ sin \left(π∗f∗dt 1 μC\right)}\right)}{π ∗ f} ;$ et
le stockage des paramètres *u_{schwell}* et *topto* dans une mémoire du microcontrôleur.

10. Appareil selon l'une quelconque des revendications 1 à 8, qui est calibré selon le procédé selon la revendication 9.

11. Appareil selon l'une quelconque des revendications 1 à 8, qui est configuré avec une fonction de calibrage automatique selon le procédé selon la revendication 9.
